# EUROPEAN PATENT APPLICATION

(11) **EP 3 243 935 A1**
(43) Date of publication of application: **15.11.2017**
(21) Application number: 17169971.3
(22) Date of filing: 08.05.2017
(51) Int. Cl.: C30B 9/06, C30B 9/10, C30B 19/04, C30B 19/08, C30B 19/12, C30B 29/36

(54) **SIC SINGLE CRYSTAL AND METHOD FOR PRODUCING SAME**

(30) Priority: 10.05.2016 JP 2016094721; 23.02.2017 JP 2017032311
(71) Applicant: TOYOTA JIDOSHA KABUSHIKI KAISHA, Toyota-shi, Aichi-ken, 471-8571 (JP); Nippon Steel & Sumitomo Metal Corporation, Tokyo 100-8071 (JP)
(72) Inventor: DAIKOKU, Hironori, Aichi-ken, 471-8571 (JP); KUSUNOKI, Kazuhiko, Tokyo, 100-8071 (JP); SEKI, Kazuaki, Tokyo, 100-8071 (JP)
(74) Representative: J A Kemp

(57) **Abstract**

Provided is a method for producing a SiC single crystal wherein a 4H-SiC single crystal is grown by minimizing generation of polytypes other than 4H. A method for producing a SiC single crystal by a solution process,
wherein a seed crystal is 4H-SiC, and a (000-1) face of the seed crystal is a growth surface,
wherein the method comprises:
setting a temperature at a center section of a region of a surface of a Si-C solution where the growth surface of the seed crystal contacts to 1900°C or higher, and
limiting a ΔTc/ΔTa to 1.7 or greater, wherein the ΔTc/ΔTa is a ratio of a temperature gradient ΔTc between the center section and a location 10 mm below the center section in the vertical direction, with respect to a temperature gradient ΔTa between the center section and a location 10 mm from the center section in the horizontal direction.

## Description

### [Technical Field]

The present disclosure relates to a method for producing a SiC single crystal.

### [Background Art]

SiC single crystals are thermally and chemically very stable, superior in mechanical strength, and resistant to radiation, and also have superior physical properties, such as high breakdown voltage and high thermal conductivity compared to Si single crystals. They are therefore able to exhibit high output, high frequency, voltage resistance and environmental resistance that cannot be realized with existing semiconductor materials, such as Si single crystals and GaAs single crystals, and are considered ever more promising as next-generation semiconductor materials for a wide range of applications including power device materials that allow high power control and energy saving to be achieved, device materials for high-speed large volume information communication, high-temperature device materials for vehicles, radiation-resistant device materials, and the like.

Typical growth processes for growing SiC single crystals that are known in the prior art include gas phase processes, the Acheson process and solution processes. Gas phase processes, such as sublimation processes, have a drawback in that grown single crystals have been prone to hollow penetrating defects known as "micropipe defects", lattice defects, such as stacking faults, and generation of heterogenous polytypes (polymorphic crystals). However, in the prior art, most SiC bulk single crystals are produced by sublimation processes, while attempts are being made to reduce defects in the grown crystals. In the Acheson process, heating is carried out in an electric furnace using silica stone and coke as starting materials, and therefore it has not been possible to obtain single crystals with high crystallinity due to impurities in the starting materials.

Solution processes are processes in which molten Si or molten Si in which a metal other than Si is melted is formed in a graphite crucible and C is dissolved into the molten liquid, and a SiC crystal layer is deposited and grown on a seed crystal substrate set in the low temperature section. Solution processes are most promising for reducing defects because crystal growth is carried out in a state of near thermal equilibrium, compared to gas phase processes, and they also tend to produce fewer heterogenous polytypes. Recently, therefore, methods for producing SiC single crystals by solution processes have been proposed.

PTL 1, for example, proposes a method for producing a hexagonal SiC single crystal in which the (000-1) face of the hexagonal SiC single crystal is used as the seed crystal substrate, and crystal growth is carried out with the temperature gradient in the depthwise direction of the molten liquid in a range of 1 to 5°C/mm. However, in prior art methods, such as described in PTL 1, even when crystal growth is conducted on a 4H-SiC seed crystal, it has been difficult to adequately carry out polytype control, and for example, 6H or 15R crystal growth is obtained, while 4H cannot be maintained.

### [Citation List]

### [Patent Literature]

[PTL 1] Japanese Unexamined Patent Publication No. 2007-197274
[PTL 2] Japanese Unexamined Patent Publication No. 2006-131433

### [Summary of the Invention]

### [Problems to be Solved by the Invention]

SiC crystals are known to have 2H, 3C, 4H, 6H and 15R polytypes (polymorphic crystals). Because the polytypes differ from each other in their physical and electrical properties, it is necessary to control the polytypes to allow application of a SiC crystal to a device. For device applications, 4H-SiC is preferably used from the viewpoint of the high hole mobility and low on-resistance when used as a power device. In prior art methods, such as that of PTL 1, however, heterogenous polytypes are produced and it has been difficult to stably obtain a 4H-SiC single crystal.

A method for producing a SiC single crystal is therefore desired that can adequately control polytypes.

### [Means for Solving the Problems]

The present inventors have carried out ardent research on control of polytypes, and have found that the temperature gradient in the horizontal direction of the Si-C solution (the direction parallel to the growth surface) is not a consideration in the prior art including PTL 1, and that when the temperature gradient in the horizontal direction has increased, the terrace width increases and heterogenous polytype nuclei are generated on the terraces, making it impossible to adequately control polytypes. Moreover, the present inventors found that if a 4H-SiC single crystal is used as the seed crystal substrate and the (000-1) face of the seed crystal substrate is used the growth surface while the temperature gradient in the horizontal direction of the Si-C solution is lowered with respect to the temperature gradient in the vertical direction, then it is possible to grow a 4H-SiC single crystal while minimizing generation of polytypes other than 4H.

The present disclosure relates to
a method for producing a SiC single crystal in which a seed crystal substrate is contacted with a Si-C solution having a temperature gradient such that a temperature of the Si-C solution decreases from an interior of the Si-C solution toward a surface of the SiC solution, to grow the SiC single crystal,
wherein the seed crystal substrate is 4H-SiC, and a (000-1) face of the seed crystal substrate is a growth surface, and
wherein the method comprises:
setting a temperature at a center section of a region of the surface of the Si-C solution where the growth surface of the seed crystal substrate contacts to 1900°C or higher, and
limiting a ΔTc/ΔTa to 1.7 or greater, wherein the ΔTc/ΔTa is a ratio of a temperature gradient ΔTc between the center section and a location 10 mm below the center section in the vertical direction, with respect to a temperature gradient ΔTa between the center section and a location 10 mm from the center section in the horizontal direction.

The present disclosure also relates to a SiC single crystal wherein a width of a terrace on a growth surface of the SiC single crystal is no greater than 11 µm and a 4H rate of the SiC single crystal is 46% or greater.

### [Effect of the Invention]

According to the method of the present disclosure it is possible to grow a 4H-SiC single crystal while minimizing generation of polytypes other than 4H.

### [Brief Description of the Drawings]

Fig. 1 is a cross-sectional schematic drawing showing a SiC single crystal production apparatus that may be used in the method of the present disclosure.
Fig. 2 is a magnified schematic diagram near the center section of the region of the surface of the Si-C solution 24 where the growth surface of the seed crystal substrate contacts.
Fig. 3 is a cross-sectional schematic drawing showing two-dimensional nuclei other than 4H generated on large-width terraces.
Fig. 4 is a cross-sectional schematic drawing showing small terrace widths, without generation of two-dimensional nuclei other than 4H.
Fig. 5 is a cross-sectional schematic drawing of the meniscus 34 formed between a seed crystal substrate 14 and a Si-C solution 24.
Fig. 6 is a Raman spectrum of a grown crystal determined as 4H.
Fig. 7 is an external photograph of an obtained grown crystal observed from the growth surface.
Fig. 8 is an optical microscope photograph showing magnification of the growth surface of an obtained grown crystal.
Fig. 9 is an external photograph of an obtained grown crystal observed from the growth surface.
Fig. 10 is an optical microscope photograph showing magnification of the growth surface of an obtained grown crystal.
Fig. 11 is a Raman spectrum of a grown crystal in which polytypes other than 4H have been generated.
Fig. 12 is an external photograph of an obtained grown crystal observed from the growth surface.
Fig. 13 is an optical microscope photograph showing magnification of the growth surface of an obtained grown crystal.
Fig. 14 is a graph representing the 4H rate with respect to ΔTc/ΔTa.
Fig. 15 is a graph representing the relationship between 4H rate and temperature at the center section of the region of the surface of the Si-C solution where the growth surface of the seed crystal substrate contacts.

### [Description of Embodiments]

Throughout the present specification, the indication "-1" in an expression, such as "(000-1) face", is used where normally a transverse line is placed over the numeral.

SiC crystals have various polytypes, with virtually no difference in free energy, and therefore when crystal growth has been performed on a 4H-SiC seed crystal substrate using solution processes in the prior art, 6H or 15R crystal growth has resulted and it has been difficult to stably obtain a 4H-SiC single crystal.

In contrast, the present inventors found that if a 4H-SiC single crystal is used as the seed crystal substrate and the (000-1) face of the seed crystal substrate serves as the growth surface while the temperature gradient in the horizontal direction of the Si-C solution is lowered with respect to the temperature gradient in the vertical direction, then it is possible to stably grow a 4H-SiC single crystal while minimizing generation of polytypes other than 4H.

The present disclosure relates to a method for producing a SiC single crystal in which a seed crystal substrate is contacted with a Si-C solution having a temperature gradient such that a temperature of the Si-C solution decreases from an interior of the Si-C solution toward a surface of the Si-C solution, to grow the SiC single crystal, wherein the seed crystal substrate is 4H-SiC, and a (000-1) face of the seed crystal substrate is a growth surface, and wherein the method comprises: setting a temperature at a center section of a region of the surface of the Si-C solution where the growth surface of the seed crystal substrate contacts to 1900°C or higher, and limiting a ΔTc/ΔTa to 1.7 or greater, wherein the ΔTc/ΔTa is a ratio of the temperature gradient ΔTc between the center section and a location 10 mm below the center section in the vertical direction, to a temperature gradient ΔTa between the center section and a location 10 mm from the center section in the horizontal direction.

According to the method of this disclosure, it is possible to grow a 4H-SiC single crystal in a stable manner while minimizing generation of polytypes other than 4H.

A solution process is used in the method of the present disclosure. A solution process is a method for producing a SiC single crystal in which a SiC seed crystal substrate is contacted with a Si-C solution having a temperature gradient wherein the temperature decreases from the interior (depth) toward the surface (liquid level), to grow a SiC single crystal. By forming a temperature gradient in which the temperature decreases from the interior of the Si-C solution toward the liquid level of the Si-C solution, the surface region of the SiC solution becomes supersaturated and a SiC single crystal is grown from the seed crystal substrate contacting with the Si-C solution.

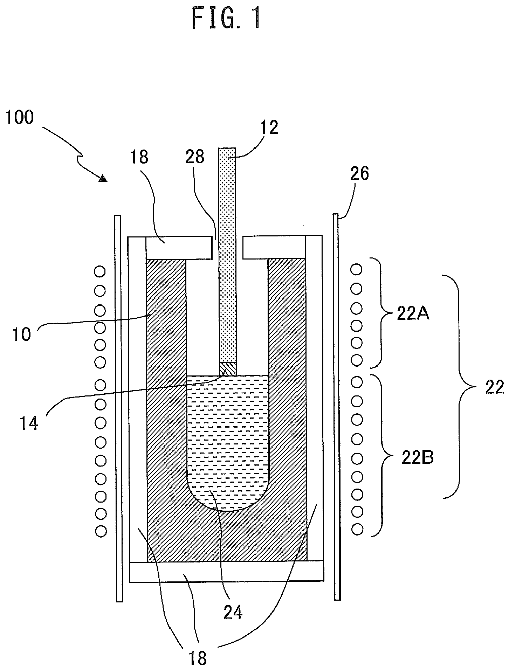

Fig. 1 shows an example of a cross-sectional schematic drawing of a SiC single crystal production apparatus that may be used in the production method of the present disclosure. The illustrated SiC single crystal production apparatus 100 comprises a crucible 10 that receives a Si-C solution 24 having C dissolved in a molten liquid of Si or Si/X (X being one or more metals other than Si), wherein a temperature gradient is formed in which the temperature is decreased from the interior of the Si-C solution toward the liquid level of the solution, and the seed crystal substrate 14 which is held at the tip of the vertically movable seed crystal holding shaft 12 is contacted with the Si-C solution 24 to allow growth of the SiC single crystal from the seed crystal substrate 14.

The C that has dissolved in the Si-C solution 24 is dispersed by diffusion and convection. Since a temperature gradient ΔTc is formed such that the region near the bottom face of the seed crystal substrate 14 is at lower temperature than the interior of the Si-C solution 24, when the C that has dissolved into the solution interior that is at high temperature and has high solubility reaches the region near the seed crystal substrate that is at low temperature and has low solubility, a supersaturated state appears and a SiC single crystal is grown on the seed crystal substrate 14 by virtue of supersaturation as a driving force.

The seed crystal substrate to be used in the method of the disclosure may be a 4H-SiC single crystal having a (000-1) face, and the seed crystal substrate may be a single crystal having quality commonly used for production of SiC single crystals. For example, a SiC single crystal commonly formed by a sublimation process may be used as the seed crystal substrate.

The seed crystal substrate may have any desired shape, such as plate-like, discoid, cylindrical, columnar, truncated circular conic or truncated pyramidal, so long as it is a 4H-SiC single crystal and has a (000-1) face.

The (000-1) face of the seed crystal substrate is the growth surface in the method of the disclosure. By using the (000-1) face of the seed crystal substrate as the growth surface, it is possible to carry out single crystal growth without metal inclusions being incorporated in the growth interface.

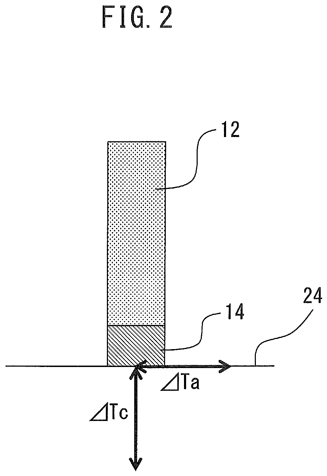

In the method of this disclosure, a ΔTc represents a temperature gradient between the temperature at the center section (center location) of the region of the surface (liquid level) of the Si-C solution 24 where the growth surface of the seed crystal substrate contacts and a location 10 mm below the center section in the vertical direction, a ΔTa represents a temperature gradient between the center section and a location 10 mm from the center section in the horizontal direction, as shown in Fig. 2, and a ΔTc/ΔTa as the ratio of the ΔTc and ΔTa is 1.7 or greater. Fig. 2 is a magnified schematic diagram near the center section of the region of the surface of the Si-C solution 24 where the growth surface of the seed crystal substrate contacts.

The ΔTc is a temperature gradient in the surface region in the direction perpendicular to the liquid level of the Si-C solution 24, which is a temperature gradient where the temperature falls from the interior of the Si-C solution toward the liquid level (surface) of the solution. The ΔTc can be calculated as the average value obtained by pre-measuring the temperature A which is the low-temperature side at the center section in the region of the surface of the Si-C solution where the growth surface of the seed crystal substrate contacts, and the temperature B which is the high-temperature side at a depth of 10 mm from the center section in the vertical direction, using a thermocouple before contacting the seed crystal substrate with the Si-C solution, and dividing the temperature difference by the distance 10 mm between the positions at which temperature A and temperature B were measured.

The ΔTa is a temperature gradient in the horizontal direction of the liquid level (surface) of the Si-C solution. The ΔTa is a temperature gradient such that the temperature increases in the horizontal direction, from the center section of the region of the surface of the Si-C solution where the growth surface of the seed crystal substrate contacts, toward the outer peripheral section. The ΔTa can be calculated as the average value obtained by pre-measuring the temperature C which is the low-temperature side at the center section in the region of the surface of the Si-C solution where the growth surface of the seed crystal substrate contacts, and the temperature D which is the high-temperature side at a location 10 mm from the center section in the horizontal direction, using a thermocouple before contacting the seed crystal substrate with the Si-C solution, and dividing the temperature difference by the distance 10 mm between the positions at which temperature C and temperature D were measured.

The ratio ΔTc/ΔTa is 1.7 or greater, preferably 2.0 or greater, more preferably 3.0 or greater, even more preferably 4.0 or greater, yet more preferably 5.0 or greater and even yet more preferably 5.3 or greater. If the ΔTc/ΔTa is within the above range, the terrace width will be reduced and step-flow growth will be promoted. It will therefore be possible to stably grow a 4H-SiC single crystal. By growing a SiC single crystal with a reduced terrace width it is possible to minimize generation of heterogenous polytypes other than 4H on the terraces, to increase the proportion of 4H SiC single crystals that are grown (hereunder referred to as "4H rate").

The ΔTc and ΔTa are not particularly restricted so long as the ΔTc/ΔTa is within the above range, but the ΔTc is preferably 5°C/cm to 50°C/cm, more preferably 7°C/cm to 30°C/cm and even more preferably 8°C/cm to 25°C/cm, and the ΔTa is preferably 0°C/cm to 15°C/cm, more preferably 0°C/cm to 8°C/cm, even more preferably 0°C/cm to 4°C/cm, yet more preferably 0°C/cm to 1.5°C/cm and most preferably 0°C/cm.

The ΔTc which is the temperature gradient in the vertical direction of the Si-C solution can be controlled by the same method used in the prior art, such as by adjusting the output of a heating device situated on the periphery of the crucible, or by the size of the opening of the covering on the top section of the crucible. For example, the output of the upper level coil 22A may be smaller than the output of the lower level coil 22B, to form a prescribed temperature gradient ΔTc in the Si-C solution 24 in which un upper portion of the solution is at low temperature while a lower portion of the solution is at high temperature. The ΔTa value which is the temperature gradient in the horizontal direction of the Si-C solution can be controlled by the inner diameter of the crucible, or by the thickness of the heat-insulating material situated on the periphery of the crucible. For example, by reducing the inner diameter of the crucible, it is possible to lower the temperature gradient ΔTa in the horizontal direction. The temperature gradient ΔTa in the horizontal direction can also be lowered by increasing the thickness of the heat-insulating material situated on the periphery of the crucible. By controlling the ΔTc and ΔTa in this manner it is possible to control the ratio ΔTc/ΔTa.

In the method of the present disclosure, the temperature at the center section in the region of the surface of the Si-C solution where the growth surface of the seed crystal substrate contacts is 1900°C or higher, preferably 1950°C or higher, more preferably 2000°C or higher and even more preferably 2050°C or higher. By limiting the temperature at the center section to within the above range it is possible to further increase the 4H rate of the SiC single crystal that is grown. The upper limit for the temperature at the center section may be up to 2200°C, for example.

According to the method of the disclosure it is possible to increase the 4H rate of the SiC single crystal that is grown to a higher level than the prior art. In the method of the disclosure, it is possible to obtain a SiC single crystal with a 4H rate of 46% or greater, preferably 50% or greater, more preferably 68% or greater, even more preferably 80% or greater, yet more preferably 90% or greater and most preferably 100%.

The 4H rate of the grown crystal can be measured by conducting Raman spectroscopy analysis of the growth surface of the grown crystal. A specific procedure for measuring the 4H rate is described in the examples below.

While it is not our intention to be constrained by theory, the mechanism by which the 4H rate is improved by the method of this disclosure may be explained as follows.

SiC crystal growth proceeds by step-flow growth. The step-flow growth is a form of crystal growth in which steps are successively formed at substantially equally spaced widths in the same orientation on the crystal growth surface. The portions of the steps that are not covered by subsequently grown steps are referred to as terraces.

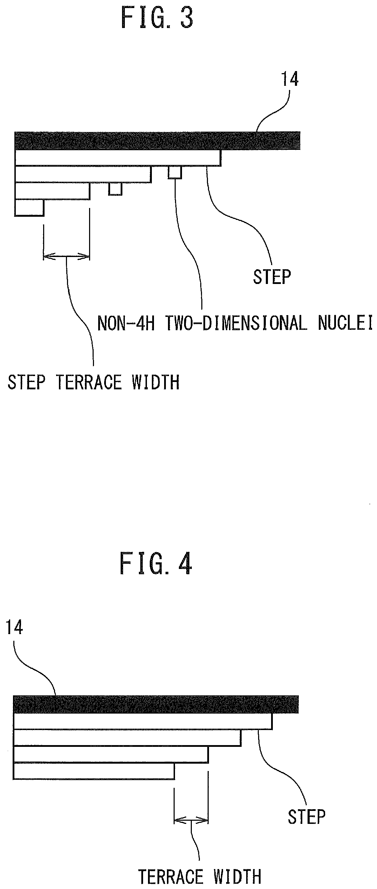

As shown in Fig. 3, an increasing terrace width during crystal growth increases the probability of generating two-dimensional nuclei other than 4H on the terraces, and such nuclei act as origins for generation of heterogenous polytypes, such as 6H and 15R. When the temperature gradient of the Si-C solution in the horizontal direction is increased with respect to the temperature gradient in the perpendicular direction, the step progression speed is more rapid and the terrace width increases. Fig. 3 is a cross-sectional schematic drawing showing two-dimensional nuclei other than 4H generated on large-width terraces.

If the temperature gradient in the horizontal direction of the liquid level of the Si-C solution is reduced, this slows the growth rate of step-flow growth that is driven by the temperature gradient in the horizontal direction of the liquid level of the Si-C solution. When the rate of step-flow growth driven by the temperature gradient in the horizontal direction of the liquid level of the Si-C solution is slowed, the terrace width is reduced, as shown in Fig. 4. A smaller terrace width presumably makes it difficult for two-dimensional nuclei other than 4H to adhere to the terraces, making it easier to stably generate a 4H-SiC crystal. Fig. 4 is a cross-sectional schematic drawing showing small terrace widths, without generation of two-dimensional nuclei other than 4H.

It is believed that the 4H rate of the SiC grown crystal is increased by the above mechanism in the method of the present disclosure.

The terraces are formed in a concentric manner at the outer peripheral section of the growth surface. According to the method of the disclosure it is possible to obtain a 4H-SiC single crystal having a terrace width on the growth surface of no greater than 11 µm and preferably no greater than 4 µm. Throughout the present application, the terrace width is the average value of the terrace widths measured by observation of 3 locations at 1 mm, 5 mm and 10 mm from the outer peripheral section of the growth surface toward the center of the growth surface, in a visual field range of 600 µm square (10x observed magnification) to 1.5 mm (20x observed magnification) with an optical microscope, the measurement being based on the optical microscope observation (magnification: 10x to 20x) of the growth surface.

The crucible is preferably a carbonaceous crucible, such as a graphite crucible, or a SiC crucible. The shape of the crucible is preferably circular cylindrical. The inner diameter of the crucible may be set as appropriate for the size of the single crystal production apparatus used, and it may be 30 to 200 mm or 40 to 120 mm, for example.

For thermal insulation, the outer periphery of the crucible 10 is covered with a heat-insulating material 18. The heat-insulating material 18 may be a graphite-based heat-insulating material, carbon fiber-molded heat-insulating material, or the like, and the thickness of the heat-insulating material may be 4 to 15 mm, for example.

In the method of the disclosure, the "Si-C solution" is a solution in which C is dissolved, the solvent being a molten liquid of Si or Si/X (X being one or more metals other than Si). X is not particularly restricted so long as it is one or more metals and can form a liquid phase (solution) that is in a state of thermodynamic equilibrium with SiC (the solid phase). Suitable examples of X metals include Ti, Mn, Cr, Ni, Ce, Co, V and Fe.

The Si-C solution is preferably a Si-C solution wherein the solvent is a molten liquid of Si/Cr/X (where X represents one or more metals other than Si and Cr). More preferred is a Si-C solution wherein the solvent is a molten liquid with an atomic composition percentage of 30-80 for Si, 20-60 for Cr and 0-10 for X (Si:Cr:X = 30-80:20-60:0-10), as it has low variation in C dissolution. For example, Cr, Ni and the like may be loaded into the crucible in addition to Si, to form a Si-Cr solution, Si-Cr-Ni solution or the like.

The Si-C solution 24 is prepared by loading the starting materials into the crucible, and melting them by heating to prepare a Si or Si/X molten liquid, and dissolving C therein. If the crucible 10 is a carbonaceous crucible, such as a graphite crucible, or SiC crucible, C will dissolve into the molten liquid by dissolution of the crucible 10, thereby allowing a Si-C solution to be formed. This will avoid the presence of undissolved C in the Si-C solution 24, and prevent waste of SiC due to deposition of the SiC single crystal onto the undissolved C. The supply of C may be carried out by utilizing a method of, for example, blowing in hydrocarbon gas or loading a solid C source together with the molten liquid starting material, or these methods may be combined together with dissolution of the crucible.

Placement of the seed crystal substrate in the single crystal production apparatus may be conducted by holding the top face of the seed crystal substrate on the seed crystal holding shaft. A carbon adhesive may be used for holding the seed crystal substrate on the seed crystal holding shaft.

The seed crystal holding shaft 12 is a shaft that holds the seed crystal substrate 14 on its end face, and it may be a graphite shaft with any desired shape, such as cylindrical or columnar.

Contact of the seed crystal substrate 14 with the Si-C solution 24 may be conducted by lowering the seed crystal holding shaft 12 holding the seed crystal substrate 14 toward the liquid level of the Si-C solution 24, and contacting it with the Si-C solution 24 while the (000-1) face, which is the bottom face of the seed crystal substrate 14, is parallel to the liquid level of the Si-C solution 24. The seed crystal substrate 14 may be held at a prescribed position relative to the liquid level of the Si-C solution 24 for growth of the SiC single crystal.

The location where the seed crystal substrate 14 is held in the horizontal direction is not particularly restricted so long as it allows crystal growth from the growth surface of the seed crystal substrate 14 with the ΔTc/ΔTa ratio in the above range and the surface temperature of the Si-C solution 24 in the temperature range specified above, but preferably it is held at approximately the center section of the surface of the Si-C solution 24 in the crucible 10.

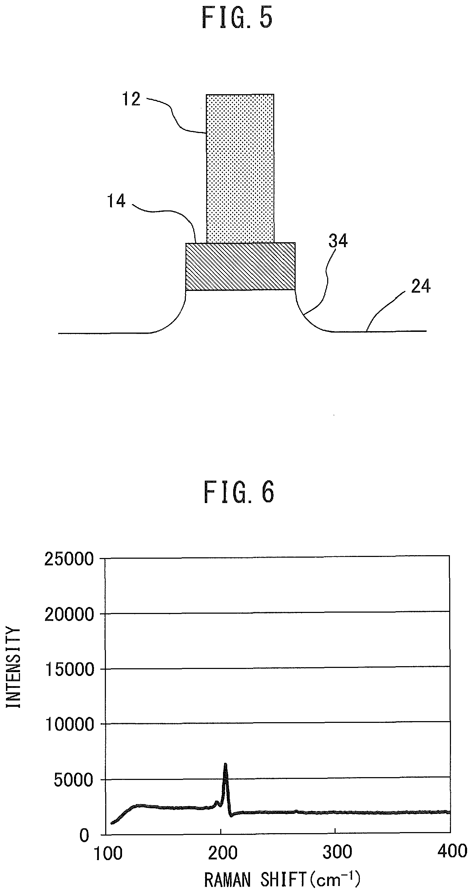

The holding position of the seed crystal substrate 14 in the vertical direction may be such that the position of the bottom face of the seed crystal substrate 14 matches the Si-C solution surface, is below the Si-C solution surface, or is above the Si-C solution surface. As shown in Fig. 5, the position of the bottom face of the seed crystal substrate may be set above the Si-C solution surface so that the Si-C solution 24 wets only the bottom face of the seed crystal substrate 14, forming a meniscus 34. Fig. 5 is a cross-sectional schematic drawing of the meniscus 34 formed between the seed crystal substrate 14 and the Si-C solution 24.

When a meniscus is formed, the position of the bottom face of the seed crystal substrate is preferably held at a position 0.5 to 3 mm above the Si-C solution surface. When it is held so that the bottom face of the seed crystal substrate is at a position above the Si-C solution surface, the seed crystal substrate is contacted once with the Si-C solution so that the Si-C solution contacts with the bottom face of the seed crystal substrate, and it is then raised to the prescribed position. By forming a meniscus and conducting crystal growth, it is possible to easily avoid contact of the SiC solution with the seed crystal holding shaft, and to prevent generation of polycrystals.

The position of the bottom face of the seed crystal substrate may match the Si-C solution surface or be lower than the Si-C solution surface, but in order to prevent generation of polycrystals, it is preferably such that the Si-C solution does not contact with the seed crystal holding shaft. In such methods, the position of the seed crystal substrate may be adjusted during growth of the SiC single crystal.

Temperature measurement of the Si-C solution can be carried out by using a thermocouple or radiation thermometer. From the viewpoint of high temperature measurement and preventing inclusion of impurities, the thermocouple is preferably a thermocouple comprising a tungsten-rhenium wire covered with zirconia or magnesia glass, placed inside a graphite protection tube.

The crucible 10 covered by the heat-insulating material 18 is fully housed in a quartz tube 26. A high-frequency coil 22 is disposed around the outer periphery of the quartz tube 26, as a heating device. The high-frequency coil 22 may configured with an upper level coil 22A and a lower level coil 22B. The upper level coil 22A and lower level coil 22B can be independently regulated.

Since the temperatures of the crucible 10, heat-insulating material 18, quartz tube 26 and high-frequency coil 22 become high, they are placed inside a water-cooling chamber. The water-cooling chamber is provided with a gas inlet and a gas exhaust vent to allow atmospheric modification in the apparatus.

The crucible 10 comprises an opening 28 at the top through which the seed crystal holding shaft 12 passes. By adjusting the gap (spacing) between the crucible 10 and the seed crystal holding shaft 12 at the opening 28, it is possible to vary the amount of radiative heat loss from the liquid level of the Si-C solution 24. Although it is usually necessary to keep the interior of the crucible 10 at high temperature, setting a large gap between the crucible 10 and the seed crystal holding shaft 12 at the opening 28 can increase radiative heat loss from the liquid level of the Si-C solution 24, while setting a small gap between the crucible 10 and the seed crystal holding shaft 12 at the opening 28 can reduce radiative heat loss from the liquid level of the Si-C solution 24. The gap (spacing) between the crucible 10 and the seed crystal holding shaft 12 at the opening 28 is preferably about 2 to 10 mm on the side. When a meniscus is formed, radiative heat loss can take place from the meniscus portion as well.

In one embodiment, meltback may be carried out in which the surface layer of the seed crystal substrate is dissolved in the Si-C solution and removed prior to growth of a SiC single crystal. Since the surface layer of the seed crystal substrate on which the SiC single crystal is to be grown may have an affected layer, such as a dislocation, a natural oxide film, or the like, removal of these by dissolution prior to growth of a SiC single crystal is effective for growing a high-quality SiC single crystal. Although the thickness of a layer to be dissolved depends on the processed conditions of the surface of a seed crystal substrate, it is preferably about 5 to 50 µm for sufficient removal of an affected layer and a natural oxide film.

The meltback may be carried out by forming in the Si-C solution a temperature gradient in which the temperature increases from the interior of the Si-C solution toward the liquid level of the Si-C solution, i.e. by forming a temperature gradient in a direction opposite to the case of the SiC single crystal growth. The temperature gradient in the opposite direction can be formed by controlling the output of the high-frequency coil.

In one embodiment, the seed crystal substrate may be preheated in advance, and then the same is contacted with the Si-C solution. If the seed crystal substrate at low temperature is contacted with the Si-C solution at high temperature, heat shock dislocation may be generated in the seed crystal. Preheating of the seed crystal substrate before contacting the seed crystal substrate with the Si-C solution prevents heat shock dislocation and is effective for growth of a high-quality SiC single crystal. The seed crystal substrate may be heated together with the seed crystal holding shaft. In this case, heating of the seed crystal holding shaft is stopped after contact of the seed crystal substrate with the Si-C solution and before growth of the SiC single crystal. Alternatively, the Si-C solution may be heated to the temperature for crystal growth after contacting the seed crystal substrate with the Si-C solution at a relatively low temperature. This is also effective for preventing heat shock dislocation and growing a high-quality SiC single crystal.

The present disclosure also relates to a SiC single crystal wherein a width of a terrace on a growth surface the SiC single crystal is no greater than 11 µm and a 4H rate of the SiC single crystal is higher than in the prior art, and especially the 4H rate is 46% or greater.

The terraces are formed in a concentric manner at the outer peripheral section of the growth surface. A 4H-SiC single crystal wherein the terrace width on the growth surface is within the above range has minimal generation of heterogenous polytype nuclei on the terraces, and therefore a SiC single crystal with a higher 4H rate than the prior art can be obtained.

The terrace width is preferably no greater than 4 µm. The 4H rate is preferably 50% or greater, more preferably 68% or greater, even more preferably 80% or greater, yet more preferably 90% or greater and most preferably 100%.

The methods for observation and measurement of the terrace width for the production method described above are similarly applied for this SiC single crystal as well.

### [Examples]

Calculation of the 4H rates in the following examples and comparative examples was performed by the following method.

The growth surface of the grown crystal was partitioned into 1 mm equal spacings, and Raman spectroscopy analysis was performed at approximately the center of each partition. The analysis conditions were as follows: Excitation wavelength: 532 nm, 20 mW, laser irradiation diameter: 2.7 µm, back scattering device, exposure time: 2 seconds, number of scans: 1, diffraction grating: 1600 gr/mm, confocal hole diameter: 10 µm, room temperature, in air.

When all of the partitions on the Raman spectroscopy-analyzed growth surface were 4H, the grown crystal was determined to be 4H-SiC. As the determination of 4H or not for each partition, 4H was determined if only a Raman peak for 4H was obtained, and non-4H was determined if Raman peaks other than 4H were observed. For the examples and comparative examples, several crystals were grown under the same conditions to obtain multiple grown crystals, the growth surfaces of the multiple grown crystals were analyzed by Raman spectroscopy, and the 4H rate was recorded as the proportion of the number of grown crystals determined to be 4H-SiC with respect to the number of multiple grown crystals. That is, a 4H rate of 100% means that, for example, among 30 grown crystals, all of the partitions on each growth surface of the 30 grown crystals are determined to be 4H-SiC, and a 4H rate of 50% means that, for example, among 30 grown crystals, all of the partitions on each growth surface of 15 grown crystals are determined to be 4H-SiC, while the remaining 15 grown crystals are determined to be not 4H-SiC. When even one among all of the partitions on the growth surface was determined to be not 4H-SiC, the grown crystal was determined to be not 4H-SiC.

### (Example 1)

The single crystal production apparatus illustrated in Fig. 1 was used. There was prepared a SiC single crystal formed by a sublimation process, which was a discoid 4H-SiC single crystal with a diameter of 12.7 mm, a thickness of 700 µm, and the bottom face as the (000-1) face, for use as a seed crystal substrate 14. A cylindrical graphite seed crystal holding shaft 12 was prepared having a diameter of 12.7 mm, a length of 200 mm, and an end face with the same shape as the top face of the seed crystal substrate. The top face of the seed crystal substrate 14 was bonded to about the center section of the end face of the seed crystal holding shaft 12 by using a graphite adhesive, with the bottom face of the seed crystal substrate 14 as the (000-1) face.

The seed crystal holding shaft 12 and seed crystal substrate 14 were situated so that the seed crystal holding shaft 12 passed through a circular opening 28 with a diameter of 18.7 mm, opened at the center section of the top covering of the crucible 10. The gap between the crucible 10 and the seed crystal holding shaft 12 at the opening 28 was 3 mm on the side.

In a graphite crucible with an inner diameter of 40 mm, with a 15 mm-thick carbon fiber felt-molded heat-insulating material situated on its periphery, there were charged Si, Cr and Ni at an atomic composition ratio of Si:Cr:Ni = 55:40:5 (at%), as a molten liquid starting material for formation of a Si-C solution.

After vacuum suction of the interior of the single crystal production apparatus to 1 × 10⁻³ Pa, argon gas was introduced to 1 atmosphere and the air inside the single crystal production apparatus was exchanged with argon. A high-frequency coil was electrified to melt the starting material in the graphite crucible by heating, thereby forming a Si/Cr/Ni alloy molten liquid. Then, a sufficient amount of C was dissolved into the Si/Cr/Ni alloy molten liquid from the graphite crucible to form a Si-C solution.

The outputs of the upper level coil and lower level coil were adjusted for heating of the graphite crucible so that the temperature at the center section in the region of the surface of the Si-C solution where the growth surface of the seed crystal substrate contacted, was increased to a temperature range of at least 1900°C and lower than 1950°C, and so that the temperature gradient ΔTc, in which the temperature in the vertical direction was decreased from the interior of the solution in a range of 10 mm from the center section of the surface of the Si-C solution, toward the liquid level of the Si-C solution, was 8°C/cm. For this example, the center section in the region of the surface of the Si-C solution where the growth surface of the seed crystal substrate contacted, is defined as the center section on the surface of the Si-C solution. The temperature gradient ΔTa between the center section on the surface of the Si-C solution and a location 10 mm from the center section of the surface in the horizontal direction was 1.5°C/cm. The ratio ΔTc/ΔTa was 5.3. Temperature measurement in the horizontal direction of the liquid level of the Si-C solution was performed with a radiation thermometer, and temperature measurement in the vertical direction of the Si-C solution was conducted by using a vertically movable thermocouple.

Seed touching was conducted, in which the position of the bottom face of the seed crystal substrate was placed at a position matching the liquid level of the SiC solution, and only the bottom face of the seed crystal substrate was contacted with the Si-C solution, while keeping the (000-1) face as the bottom face of the seed crystal substrate that was bonded to the seed crystal holding shaft 12, parallel to the Si-C solution surface, and the substrate was held at that position for 10 hours to grow a crystal.

Upon completion of the crystal growth, the seed crystal holding shaft 12 was raised, and the seed crystal substrate 14 and the SiC single crystal grown from the seed crystal substrate were severed from the Si-C solution 24 and the seed crystal holding shaft 12 and were recovered. Crystal growth was then carried out 26 times under the same conditions, to obtain a total of 27 grown crystals.

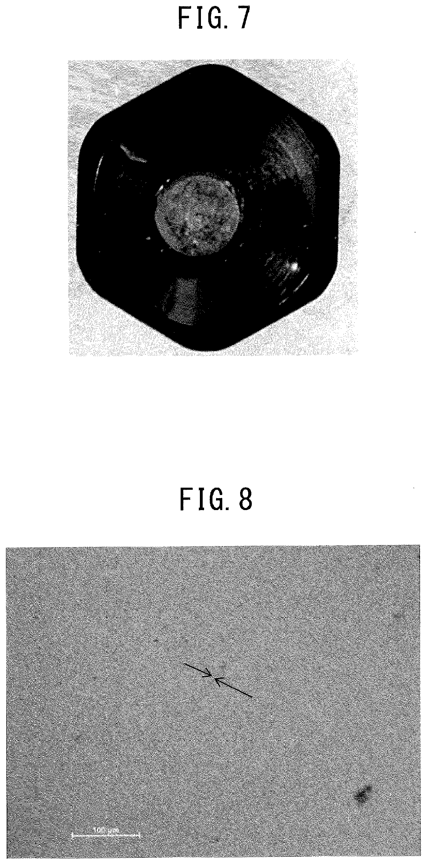

When the polytypes of the grown crystals were examined by Raman spectroscopy analysis, the 4H rate for the obtained 27 grown crystals was 100%. The 4H rate was calculated by the method described above. Fig. 6 shows a Raman spectrum of a grown crystal determined as 4H. A peak for 4H was observed at 204 cm⁻¹, but no peaks were observed for polytypes other than 4H. Fig. 7 shows an external photograph of the obtained grown crystal observed from the growth surface. The thickness of the grown crystal was 2.8 mm. The three locations of 1 mm, 5 mm and 10 mm from the outer peripheral section of the growth surface of the grown crystal toward the center of the growth surface were observed at a magnification of 20x in a 600 µm square region using an optical microscope, and the terrace width of the growth surface of the grown crystal was found to be 4 µm. Fig. 8 shows an optical microscope photograph in which the growth surface of the obtained grown crystal is magnified. The terrace width is indicated between arrows.

### (Example 2-1)

SiC single crystals were grown and recovered under the same conditions as Example 1, except for using a SiC single crystal with a diameter of 50.4 mm as the seed crystal substrate, and a graphite crucible with an inner diameter of 70 mm, setting the ΔTc to 25°C/cm and the ΔTa to 15°C/cm, for a ΔTc/ΔTa value of 1.7, and conducting crystal growth 13 times.

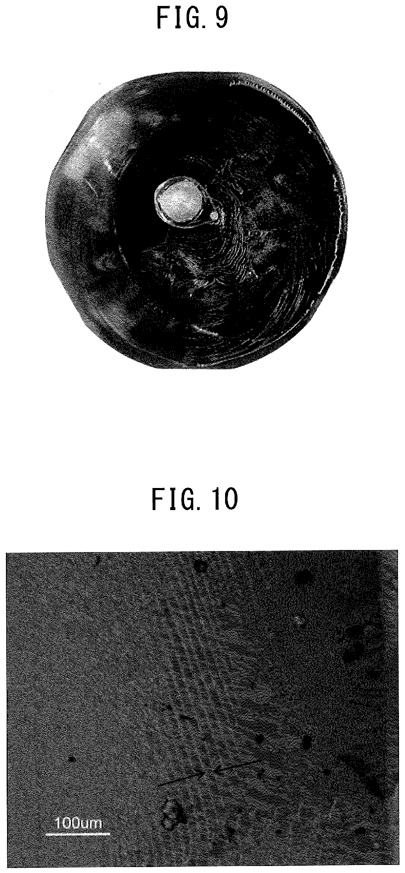

The 4H rate for the obtained 13 grown crystals was 46%. Fig. 9 shows an external photograph of an obtained grown crystal observed from the growth surface. The thickness of the grown crystal was 2.4 mm. The three locations of 1 mm, 5 mm and 10 mm from the outer peripheral section of the growth surface of the grown crystal toward the center of the growth surface were observed at a magnification of 20x in a 600 µm square region using an optical microscope, and the terrace width of the growth surface of the grown crystal was found to be 11 µm. Fig. 10 shows an optical microscope photograph in which the growth surface of the obtained grown crystal is magnified. The terrace width is indicated between arrows.

### (Example 2-2)

SiC single crystals were grown and recovered under the same conditions as Example 2-1, except that the temperature at the center section on the surface of the Si-C solution was 1950°C or higher and below 2000°C, and crystal growth was conducted 25 times in that temperature range.

The 4H rate for the obtained 25 grown crystals was 68%.

### (Example 2-3)

SiC single crystals were grown and recovered under the same conditions as Example 2-1, except that the temperature at the center section on the surface of the Si-C solution was 2000°C or higher and below 2050°C, and crystal growth was conducted 10 times in that temperature range.

The 4H rate for the obtained 10 grown crystals was 70%.

### (Example 2-4)

SiC single crystals were grown and recovered under the same conditions as Example 2-1, except that the temperature at the center section on the surface of the Si-C solution was 2050°C or higher and below 2100°C, and crystal growth was conducted 18 times in that temperature range.

The 4H rate for the obtained 18 grown crystals was 100%.

### (Example 3)

SiC single crystals were grown and recovered under the same conditions as Example 1, except for placing a heat-insulating material with a thickness of 8 mm around the periphery of the crucible, setting the ΔTc to 8°C/cm and the ΔTa to 4°C/cm, for a ΔTc/ΔTa value of 2.0, and conducting crystal growth 11 times.

The 4H rate for the obtained 11 grown crystals was 100%.

### (Comparative Example 1-1)

SiC single crystals were grown and recovered under the same conditions as Example 1, except for using a SiC single crystal with a diameter of 50.4 mm as the seed crystal substrate, and a graphite crucible with an inner diameter of 120 mm, setting the ΔTc to 1.5°C/cm and the ΔTa to 3°C/cm, for a ΔTc/ΔTa value of 0.5, and conducting crystal growth 10 times.

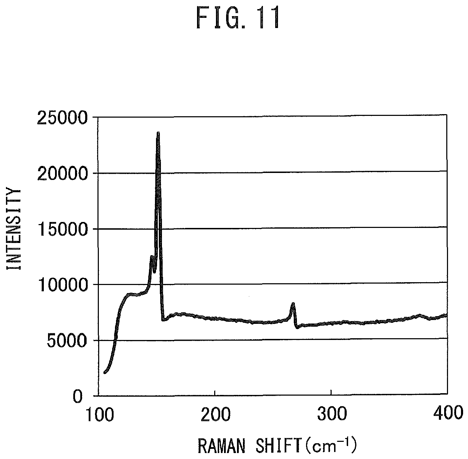

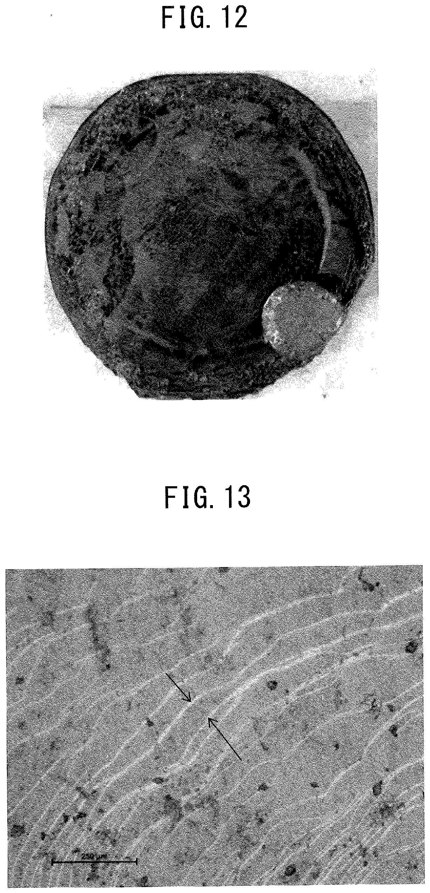

The 4H rate for the obtained 10 grown crystals was 0%. Fig. 11 shows the Raman spectrum of a grown crystal in which polytypes other than 4H have been generated. A peak for 6H was observed at 155 cm⁻¹, but no peak for 4H was observed. Fig. 12 shows an external photograph of an obtained grown crystal observed from the growth surface. The thickness of the grown crystal was 2.3 mm. The three locations of 1 mm, 5 mm and 10 mm from the outer peripheral section of the growth surface of the grown crystal toward the center of the growth surface were observed at a magnification of 10x in a 1.5 mm square region using an optical microscope, and the terrace width of the growth surface of the grown crystal was found to be 56.8 µm. Fig. 13 shows an optical microscope photograph in which the growth surface of the obtained grown crystal is magnified. The terrace width is indicated between arrows.

### (Comparative Example 1-2)

SiC single crystals were grown and recovered under the same conditions as Comparative Example 1-1, except that the temperature at the center section on the surface of the Si-C solution was 1950°C or higher and below 2000°C, and crystal growth was conducted 18 times in that temperature range.

The 4H rate for the obtained 18 grown crystals was 0%.

### (Comparative Example 1-3)

SiC single crystals were grown and recovered under the same conditions as Comparative Example 1-1, except that the temperature at the center section on the surface of the Si-C solution was 2000°C or higher and below 2050°C, and crystal growth was conducted 56 times in that temperature range.

The 4H rate for the obtained 56 grown crystals was 0%.

### (Comparative Example 1-4)

SiC single crystals were grown and recovered under the same conditions as Comparative Example 1-1, except that the temperature at the center section on the surface of the Si-C solution was 2050°C or higher and below 2100°C, and crystal growth was conducted 26 times in that temperature range.

The 4H rate for the obtained 26 grown crystals was 0%.

### (Comparative Example 2)

SiC single crystals were grown and recovered under the same conditions as Example 1, except for placing a heat-insulating material with a thickness of 4 mm around the periphery of the crucible, setting the ΔTc to 8°C/cm and the ΔTa to 8°C/cm, for a ΔTc/ΔTa value of 1.0, and conducting crystal growth 28 times.

The 4H rate for the obtained 28 grown crystals was 35.7%.

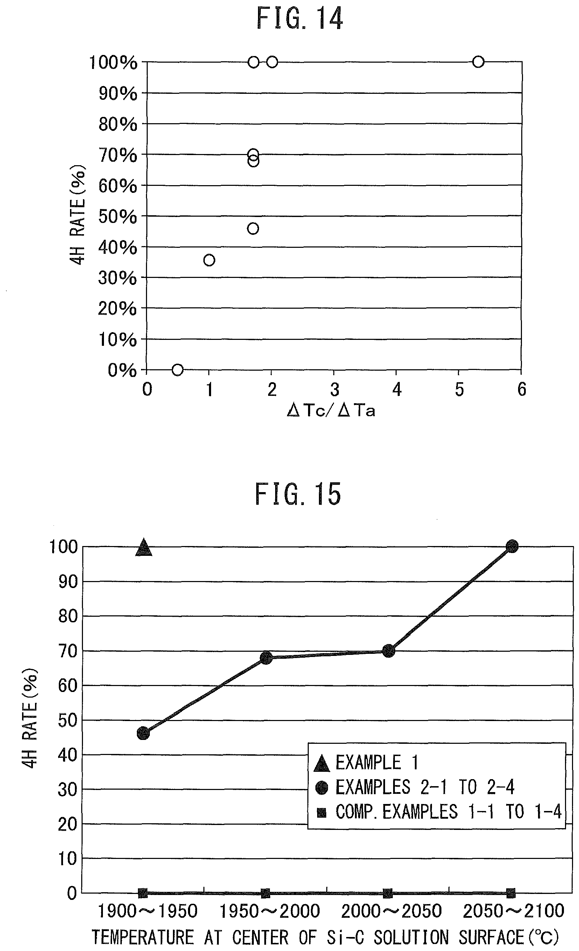

Table 1 shows the values for ΔTc, ΔTa, ΔTc/ΔTa and 4H rate in Examples 1, 2-1 to 2-4 and 3 and Comparative Examples 1-1 to 1-4 and 2. Fig. 14 shows a graph representing the 4H rates with respect to the ΔTc/ΔTa for the examples and comparative examples. Fig. 15 is a graph representing the relationship between 4H rate and temperature at the center section on the surface of the Si-C solution, for Example 1, Examples 2-1 to 2-4 and Comparative Examples 1-1 to 1-4.

**[Table 1]**

| | ΔTa (°C/cm) | ΔTc (°C/cm) | ΔTc/ ΔTa | Temperature at center of Si-C solution surface (°C) | 4H rate (n = number of grown crystals) |
|---|---|---|---|---|---|
| Example 1 | 1.5 | 8.0 | 5.3 | 1900-1950 | 100% (n=27) |
| Example 2-1 | 15 | 25 | 1.7 | 1900-1950 | 46% (n=13) |
| Example 2-2 | 15 | 25 | 1.7 | 1950-2000 | 68% (n=25) |
| Example 2-3 | 15 | 25 | 1.7 | 2000-2050 | 70% (n=10) |
| Example 2-4 | 15 | 25 | 1.7 | 2050-2100 | 100% (n=18) |
| Example 3 | 4.0 | 8.0 | 2.0 | 1900-1950 | 100% (n=11) |
| Comp. Ex. 1-1 | 3.0 | 1.5 | 0.5 | 1900-1950 | 0% (n=10) |
| Comp. Ex. 1-2 | 3.0 | 1.5 | 0.5 | 1950-2000 | 0% (n=18) |
| Comp. Ex. 1-3 | 3.0 | 1.5 | 0.5 | 2000-2050 | 0% (n=56) |
| Comp. Ex. 1-4 | 3.0 | 1.5 | 0.5 | 2050-2100 | 0% (n=26) |
| Comp. Ex. 2 | 8 | 8 | 1 | 1900-1950 | 35.7% (n=28) |

### [Explanation of Symbols]

- 100: Single crystal production apparatus
- 10: Crucible
- 12: Seed crystal holding shaft
- 14: Seed crystal substrate
- 18: Heat-insulating material
- 22: High-frequency coil
- 22A: Upper level high-frequency coil
- 22B: Lower level high-frequency coil
- 24: Si-C solution
- 26: Quartz tube
- 28: Opening at top of crucible
- 34: Meniscus

## Claims

1. A method for producing a SiC single crystal in which a seed crystal substrate is contacted with a Si-C solution having a temperature gradient such that a temperature of the Si-C solution decreases from an interior of the Si-C solution toward a surface of the SiC solution, to grow the SiC single crystal,
wherein the seed crystal substrate is 4H-SiC, and a (000-1) face of the seed crystal substrate is a growth surface, and
wherein the method comprises:
setting a temperature at a center section of a region of the surface of the Si-C solution where the growth surface of the seed crystal substrate contacts to 1900°C or higher, and
limiting a ΔTc/ΔTa to 1.7 or greater,
wherein the ΔTc/ΔTa is a ratio of a temperature gradient ΔTc between the center section and a location 10 mm below the center section in the vertical direction, with respect to a temperature gradient ΔTa between the center section and a location 10 mm from the center section in the horizontal direction.

2. The method for producing a SiC single crystal according to claim 1, wherein the temperature at the center section is 1950°C or higher.

3. The method for producing a SiC single crystal according to claim 1 or 2, wherein a holding position of the seed crystal substrate in the horizontal direction is the center section on the surface of the Si-C solution.

4. A SiC single crystal wherein a width of a terrace on a growth surface of the SiC single crystal is no greater than 11 µm and a 4H rate of the SiC single crystal is 46% or greater.
